(19) Europäisches Patentamt
European Patent Office
Office européen des brevets

(11) Numéro de publication: **0 145 613**
**B1**

# (12) FASCICULE DE BREVET EUROPÉEN

(45) Date de publication du fascicule du brevet: **15.11.89**

(51) Int. Cl.⁴: **H 05 K 1/03**

(21) Numéro de dépôt: **84420175.6**

(22) Date de dépôt: **17.10.84**

## (54) Substrats métallisables pour circuits imprimés, leur procédé de préparation.

(30) Priorité: **28.10.83 FR 8317507**

(43) Date de publication de la demande: **19.06.85 Bulletin 85/25**

(45) Mention de la délivrance du brevet: **15.11.89 Bulletin 89/46**

(84) Etats contractants désignés: **AT BE CH DE FR GB IT LI LU NL SE**

(56) Documents cité:
**EP-A-0 052 061**
**DE-A-2 814 633**
**FR-A-1 264 352**
**FR-A-2 518 126**

(73) Titulaire: **CIBA- GEIGY AG, Klybeckstrasse 141, CH-4002 Basel (CH)**

(72) Inventeur: **Cassat, Robert, Chemin de Crapon, F-69360 Ternay (FR)**

EP 0 145 613 B1

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

LIBER, STOCKHOLM 1989

## Description

La présente invention se rapporte à des substrats faits en une matière polymérique renforcée, métallisables par traitement de réduction éventuellement suivi d'une métallisation par voie électrolytique, destinés à la réalisation de circuits imprimés ainsi qu'aux substrats métallisés obtenus. Ces substrats métallisés sont désignés, dans la terminologie anglo-saxonne, par l'appellation "metal-clad".

La présente invention concerne aussi un procédé de fabrication desdits substrats.

De tels substrats métallisés sont bien connus de l'homme de l'art (cf. brevet américain N° 4 110 147 ou EP-A-52 061). Ils comprennent généralement un matériau support isolant électriquement sur la face ou les deux faces duquel adhère une feuille métallique conductrice. Cette feuille métallique peut être notamment une feuille de cuivre, d'aluminium, de nickel, ou d'acier inoxydable ayant une épaisseur comprise entre 10 et 100 micromètres selon le type de circuit imprimé que l'on désire obtenir.

Les substrats métallisés dont on parle peuvent être rigides, semi-rigides ou flexibles selon la composition du matériau support isolant. Par substrat semi-rigide, on désigne un matériau pouvant supporter une déformation élastique par incurvation jusqu'à un rayon de courbure très faible.

Dans le cas des substrats métallisés rigides ou semi-rigides qui sont plus particulièrement visés par la présente invention, le matériau support isolant est constitué habituellement par l'empilement d'un certain nombre de préimprégnés qui résultent chacun de l'association, connue en soi, d'une charge de renforcement à structure allongée avec une matière polymerique. Avec une charge de renforcement courante telle que par exemple un tissu de verre de 200 g/$m^2$ ou une feuille de papier imprégnée, on fait appel en moyenne à 6 à 12 préimprégnés. Les préimprégnés courants sont composés de papiers de cellulose, de tissus de coton ou de tissus de verre imprégnés à l'aide de polymères synthétiques. Les résines phénol-formol, polyester et surtout époxydes sont les produits les plus souvent employés. La charge de renforcement, papier ou tissu de verre, est en général imprégnée à l'aide d'une solution de polymère dans un solvant adéquat, ce qui permet une bonne pénétration du liant polymérique entre les fibres de la charge. La structure imprégnée passe ensuite dans un four porté à une température permettant l'évaporation du solvant. Cette technique est généralement appelée "voie collodion".

La fabrication des substrats métallisés consiste à interposer entre les plateaux d'une presse l'empilement des préimprégnés recouvert d'une feuille métallique sur l'une ou sur ses deux faces suivant que l'on désire obtenir un substrat mono- ou bimétallisé. On presse ensuite à une température permettant l'association des différents constituants. Dans certains cas, les feuilles métalliques demandent l'intervention d'un moyen de collage pour adhérer de manière permanente sur les préimprégnés.

Pour des raisons économiques évidentes, il est souhaitable d'accroître les rendements de fabrication en réduisant le nombre des éléments, en particulier le nombre de préimprégnés, entrant dans leur constitution. Cette simplification au niveau de la fabrication doit être faite bien entendu sans entraîner une baisse des propriétés mécanques et électriques.

Un autre but que vise la présente invention est de fournir des substrats métallisables et métallisés dont la fabrication ne doit pas donner lieu à une pollution de l'environnement. Comme on l'a indiqué ci-avant, la préparation du matériau support isolant fait intervenir généralement un processus d'imprégnation d'une série de structures de renforcement à l'aide d'une solution de polymère dans un solvant adéquat. Afin d'obtenir un préimprégné utilisable pour la suite des opérations, on doit éliminer le solvant par séchage. Cette élimination du solvant, en dépit de toutes les précautions prises pour le récupérer, est souvent une cause de pollution. On ajoutera comme autres inconvénients liés à l'emploi de solvant, d'une part son prix d'achat, et d'autre part l'importante quantité d'énergie requise pour le séchage. La réduction du nombre des préimprégnés, dont on a parlé ci-avant pour simplifier la fabrication des substrats métallisés, apparait donc encore comme une manière de résoudre ce problème de pollution. La présente invention vise d'ailleurs à résoudre complètement ce problème en proposant d'écarter la voie collodion pour la préparation des préimprégnés restants. Un autre but encore de la présente invention est de fournir des substrats métallisés pour circuits imprimés qui peuvent facilement être percés par un simple poinçonnement et dont la composition interne permet d'obtenir, en appliquant cette technique de perçage simplifiée, des trous à paroi nette pour le passage des jonctions électriques entre les deux faces.

Il est connu du brevet français 1 264 352 d'obtenir des substrats métallisables par traitement de réduction, destinés à la réalisation de circuits imprimés. Les substrates connus comprennent une âme centrale et sur une ou deux faces au moins une couche de protection dont certaines parties ont été enlevées, ces parties formant le dessin du circuit que l'on veut réaliser. Cette méthode est connu comme technologie papetière.

FR-A-1 264 352 indique que l'inclusion de fines particules d'oxyde cuivreux à au moins une partie du support confère des propriétés isolantes à cette partie et que le traitment de certaines portions de cet oxyde par de l'acide sulfurique permetterait de les convertir en un circuit conducteur. La réduction de l'oxyde cuivreux par un acide fait intervenir la formation d'un sel cuivreux instable qui se dismute en sel cuivrique et en cuivre métallique. Une partie notable du cuivre ainsi réduit est dissouté par l'agent acide utilisé. La surface n'est pas conductrice après réduction.

Le brevet français 2 518 126 concerne la réduction de l'oxyde cuivreux en cuivre métallique par action des borohydrures. Les substrats contenant cet oxyde peuvent être métallisées et sont après suffisamment conductrices.

D'autres buts et avantages de la présante invention apparaîtront au cours de la description qui va suivre. Il a

maintenant été trouvé que l'on pouvait arriver à tout ou partie de ces buts grâce à de nouveaux substrats métallisés conformes à la présante invention et/ou grâce à leur procédé de fabrication qui va être décrit dans ce qui suit.

Ces substrats métallisables par traitement de réduction éventuellement suivi d'une métallisation par voie électrolytique, destinés à la réalisation de circuits imprimés comprenant une âme centrale constituée essentiellement d'une résine thermodurcissable renfermant éventuellement une charge inerte, et sur une ou deux faces au moins une couche obtenue par chauffage et pressage à partir d'une composition de résine thermodurcissable chargée par un oxyde métallique non conducteur, et dont le degré d'oxydation est choisi de manière à permettre une réduction facile par un borohydrure et qui est susceptible de former intermédiairement des hydrures métalliques instables et ils sont caractérisés en ce que l'âme centrale comprend en outre de matière fibreuse cellulosique et/ou de paillettes de mica.

Par l'expression matière cellulosique, on entend des fibres formées de cellulose naturelle ou de cellulose modifiée par des procédés chimiques sous forme de pâte à papier ou de fibres plus ou moins défibrillées.

Les paillettes de mica mises en ouevre sont les produits habituellement disponibles dans le commerce. Ces paillettes peuvent être utilisées à l'état brut, mais dans certains cas, dans le but d'améliorer l'accrochage entre le mica et la résine, il peut être avantageux de leur faire subir un traitement de surface connu en soi.

La résine thermodurcissable constituant l'âme centrale est avantageusement choisie parmi les résines de type phénolique telles que par exemple les condensats de phénol, résorcinol, crésol ou xylénol avec du formaldéhyde ou du furfural ou de l'acetaldéhyde ou les résines du type époxy telles que par exemple les produits de réaction de l'épichlorhydrine sur le bisphénol A.

Ces résines à l'état de prépolymère doivent être sous forme de poudre pour être mises en oeuvre selon la technique dite "voie papetière" qui sera plus amplement décrite ci-après;

On préférera les résines phénoliques novolaque en poudre contenant de l'hexaméthylènetétramine comme agent de durcissement.

L'âme centrale peut aussi comporter des charges inertes, minérales et pulvérulentes comme les silicates, les carbonates, le kaolin, la craie, le pulvérisé...

L'âme centrale représente en générale 50 à 90 pourcent en poids du substrat métallisable. Sa fonction essentielle est d'assurer le remplissage du substrat métallisable (ou du substrat métallisé) de manière à permettre au dit substrat de présenter l'épaisseur requise, épaisseur de l'ordre de 1 à 3 mm.

Dans cette âme centrale, la proportion pondérale de matière cellulosique et/ou de paillettes de mica (charges de renforcement par rapport à l'ensemble - charges de renforcement et résine) est généralement comprise entre 20 et 90 %, et de préférence entre 40 et 70 %. Comme cela a été indiqué précédemment, l'âme centrale des substrats en cause est enduite sur une ou deux faces d'au moins un couche obtenue à partir d'une composition de résine thermodurcissable chargée par un oxyde métallique présentant diverses caractéristiques.

La résine thermodurcissable en cause qui constitue 30 à 70 % en poids de la composition est du type phénolique ou du type "époxy" comme décrit ci-avant ou, de préférence, du type de polymère à groupements imides comme les polyamide-imides ou les polyimides. Comme polyimide on utilise de préférence un prépolymère obtenu à partir d'un N,N'bis-imide d'acide dicarboxylique non saturé de formule générale:

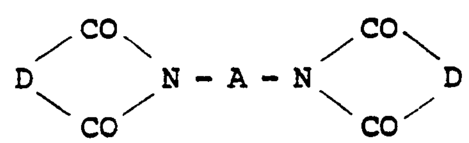 (1)

dans laquelle D représente un radical divalent contenant une double liaison carbone et A est un radical organique divalent possédant 2 à 30 atomes de carbone, et d'une polyamine de formule générale:

$R(NH_2)_x$ (2)

dans laquelle x est un nombre entier au moins égal à 2 et R représente un radical organique de valence x, la quantité de bis-imide étant de 0,55 à 25 moles par groupement molaire $-NH_2$ apporté par la polyamine.

De tels polyimides sont décrits en particulier dans le brevet français 1 555 564 mais de nombreux dérivés de ces polymères peuvent convenir. Ainsi la résine polyamide peut encore être obtenue par réaction entre le bis-imide, la polyamine et divers adjuvants tels que par exemple des mono-imides (selon le brevet français N° 2 046 498), des monomères, autres que des imides, comportant un ou plusieurs groupements polymérisables du type $- CH = C =$ (selon le brevet français N° 2 094 607), des polyesters insaturés (selon le brevet français N° 2 102 878) ou des composés organosiliciques hydroxylés (selon le brevet français N° 2 422 696). Dans le cas où l'on utilise de pareils adjuvants, il faut rappeler que la résine polyimide peut être obtenue soit chauffant directement les trois réactifs (bis-imide, polyamine et adjuvants) ensemble, soit en chauffant le produit de réaction ou le mélange de l'adjuvant avec un prépolymère de bis-imide et de polyamine préalablement préparé.

On choisira de toute façon des prépolymères qui peuvent se trouver sous forme de poudre. Plus préférentiellement encore, on utilise dans la présente invention une résine polyimide issue de la réaction entre un bis-maléimide comme le N,N'-4,4' -diphénylméthane bis-maléimide et une diamine primaire comme le diamino-4, 4' diphénylméthane et éventuellement l'un des divers adjuvants précités.

Les prépolymères de polyamide-imides utilisés comme liants dans l'invention peuvent être définis comme

comportant une pluralité de motifs de formule:

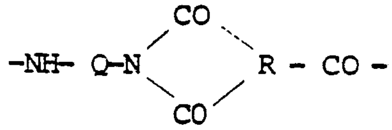 (I)

dans laquelle le symbole Q représente un radical divalent comportant au moins un noyau benzénique et le symbole R représente un radical aromatique trivalent.

Comme exemples de radicaux représentés par Q, on peut citer les radicaux m-phénylène, p-phénylène, p.p'diphénylène ou des radicaux de formule:

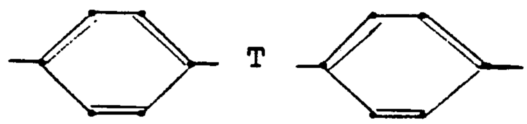 (II)

dans laquelle le symbole T peut représenter un atome ou groupement divalent tel que -O-, $CH_2$-, -$(CH_3)_2$ -$SO_2$- -N = N-.

Comme exemples de radicaux représentés par le symbole R, on peut citer les radicaux trivalents de formules:

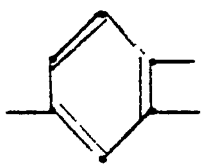 , 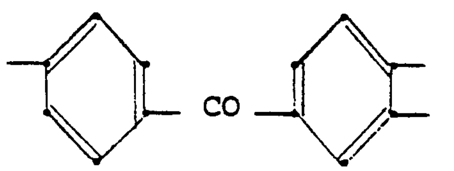 , 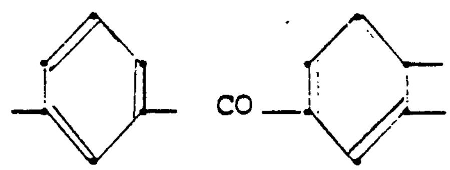

Les polyamide-imides décrits ci-avant peuvent être préparés suivant diverses techniques telles que celles décrites dans les brevets anglais 570 878 et 1 281 446, le brevet américain 3 260 691, les brevets français 1 386 617, 1 473 600, 1 501 198, 1 559 357 ou 1 576 844.

Parmi ces polyamide-imides on mentionnera en particulier ceux qui sont obtenus à partir d'anhydride trimellique et d'un dérivé difonctionnel de formule:

X - Q - X (III)

dans laquelle le symbole X représente un groupement NCO ou un groupement de formule -$NHCOR_1$, le symbole pouvant représenter un radical alcoyle ayant de 1 à 6 atomes de carbone ou un radical phényle ou méthylphényle.

On utilise de préférence dans l'invention des polyamide-imides permettant la présentation du polymère sous forme de poudre. Les polytrimellamide-imides provenant de la réaction de l'anhydride trimellique avec le diisocyanato-4,4' diphénylméthane ou diisocyanato-4,4' diphényléther conviennent à la fabrication des substrats conformes à l'invention.

Comme cela a été indiqué ci-avant, la composition renferme, outre la résine thermodurcissable dont il vient d'être question un oxyde métallique non conducteur dont le degré d'oxydation est choisi de manière à permettre une réduction facile par un borohydrure et qui est susceptible de former intermédiairement des hydrures métalliques instables.

Ledit oxyde qui constitue de 30 à 70 % en poids de la composition se présente avantageusement sous la forme de particules de très petites dimensions. Leur granulomètrie est de préférence comprise entre 0,1 et 5 micromètres. On recourt avantageusement à de l'oxyde cuivreux. Cette composition peut être sous forme pulvérulente ou sous forme de dispersion dans l'eau ou dans un mélange eau-solvant léger ou sous forme de solution. Elle peut, le cas échéant, renfermer en outre jusqu'à 40 % en poids de charges inertes, comme indiqué ci-avant pour l'âme centrale.

La dite composition peut être déposée à la surface de l'âme centrale par différents moyens connus en eux-mêmes : pistolletage, enduction au trempé ou au racle.

Dans une variante la ou les couches externes peuvent aussi être constituées par une feuille de renforcement poreuse en non-tissé ou en papier, sur laquelle est déposée la composition thermodurcissable. L'ensemble - feuille de renforcement et enduit - est disposé à la surface de l'âme centrale.

Pour préparer les substrats métallisables, selon l'invention on recourt avantageuseusement à la voie papetière.

Selon la voie papetière, on incorpore directement l'ensemble des ingrédients dans le mélange appelé "pile" par les papetiers, c'est à dire à la fois l'eau, la charge de renforcement (matière cellulosique ou mica) et le liant (prépolymère thermodurcissable) sous forme de poudre et éventuellement la charge inerte. A partir de la pâte obtenue on forme ensuite, sur une machine à papier, le feutre dont on extrait l'eau, d'une part par essorage et application du vide, d'autre part par séchage à une température de l'ordre de 70 à 105°C, en général par passage du feutre dans une étuve ventilée. Dans ce feutre le liant se trouve toujours au stade de prépolymère.

Le feutre ainsi préparé présente une densité comprise entre 0,3 et 2, alors que, au stade final, c'est à dire après pressage du feutre et durcissement du prépolymère, la densité de l'âme centrale est de 1,5 à 2,7 environ.

Avant ou après pressage du feutre ainsi préparé, on enduit une ou les faces avec une composition constituée par un mélange de résine thermodurcissable et d'oxyde métallique comme indiqué précédemment.

Cette composition qui peut se présenter sous des formes diverses déjà énumérées, peut être déposée à la surface du feutre par les différents moyens connus précédement évoqués.

Les substrats obtenus à partir du feutre enduit sont découpés en format puis pressés à chaud. On met en oeuvre habituellement une presse à plateau travaillant sous 10 à 300 bars et une température supérieure à 70°C. On peut prévoir des cycles durant lesquels pression et température sont augmentés par paliers. Ceci dépend essentiellement de la nature du liant choisi.

Dans le cas des prépolymères polyimides préférés obtenus à partir d'un bis-imide, d'une polyamine et éventuellement d'un des adjuvants précités (ayant en général un point de ramollissement compris entre 50° et 200°C), la température de pressage se situe généralement entre 70° et 280°C. De préférence, dans le but de permettre un accrochage (ou assemblage) efficace des différents constituants, la température est supérieure à 150°C.

Ces conditions de température de pressage s'appliquent également aux autres types de prépolymères thermodurcissables entrant dans le cadre de la présente invention. En général, le chauffage des prépolymères permet d'obtenir successivement leur ramollissement et leur durcissement. On peut naturellement procéder à un recuit de l'ensemble.

La technique de fabrication des substrats métallisables conformes à l'invention qui vient d'être décrite présente de nombreux avantages.

Comme on l'a déjà mentionné, cette fabrication est simplifiée du fait de l'emploi d'un nombre restreint de constituants et elle permet de s'affranchir du processus d'imprégnation de structure de renforcement par voie collodion qui est polluant.

Mais il y a d'autres avantages. La préparation du carton par voie papetière est un procédé à grand rendement. De plus, la voie papetière autorise le recyclage des déchets: il n'y a aucun inconvénient à réintroduire dans la pile les déchets de carton formés avant pressage. Par ailleurs, on note qu'il n'y a pratiquement pas de fluage de polymère lors du pressage final à chaud ce qui revêt un très grand intérêt lorsqu'on met en oeuvre un polyimide. En définitive, cette possibilité de recyclage, liée au fluage pratiquement nul lors du pressage, assure une perte très faible de résine en cours de fabrication.

Les formats pressés à chaud éventuellement recuits peuvent ensuite subir un traitement en vue de leur métallisation.

La métallisation peut être réalisée par dépôt d'une couche comportant une substance qui pourra par un traitement chimique ultérieur être transformé en métal ou qui servira d'amorce à un dépôt métallique par voie électrolytique ou chimique. On pourra réaliser cette métallisation par traitement chimique direct du substrat qui contient alors en surface un composé capable d'être transformé en métal, puis le cas échéant la conforter au moyen d'une métallisation électrolytique; cette aptitude constitue un avantage essentiel des substrats selon l'invention.

La traitement chimique du substrat en cause en vue de sa métallisation, comprend la transformation quantitative de l'oxyde métallique et plus particulièrement de l'oxyde cuivreux en métal par action des borohydrures selon la réaction:

$$4\,Cu_2O + BH_4^- \rightarrow 8\,Cu + B(OH)_3 + CH^-$$

Il pourra être nécessaire au préalable de mettre au jour les grains d'oxyde métallique par traitement mécanique (sablage, rouleaux abrasifs, frottements avec une pâte abrasive) et/ou traitement chimique.

Les borohydrures utilisables dans cette opération englobent des borohydrures substitués aussi bien que des borohydrures non substitués. Des borohydrures substitués dans lesquels au plus trois atomes d'hydrogène de l'ion borohydrure ont été remplacés par des substituants inertes comme par exemple des radicaux alkyles, des radicaux aryles, des radicaux alkoxy peuvent être utilisés. On fait appel de préférence à des borohydrures alcalins dans lesquels la partie alcaline consiste en du sodium ou du potassium. Des exemples typiques de composés qui conviennent sont: le borohydrure de sodium, le borohydrure de potassium, le diéthylborohydrure de sodium, le triméthoxyborohydrure de sodium, le triphénylborohydrure de potassium.

Le traitement réducteur est conduit de manière simple par mise en contact du substrat ou d'un format pris dans ce substrat avec une solution de borohydrure dans l'eau ou dans un mélange d'eau et d'un solvant polaire inerte comme par exemple un alcool aliphatique inférieur. On donne la préférence aux solutions purement aqueuses de borohydrure. La concentration de ces solutions peut varier dans de larges limites et elle se situe de préférence entre 0,05 et 1 % en poids d'hydrogène actif du borohydrure par rapport à la solution. Le traitement réducteur peut être effectué à température élevée, cependant on préfère le mettre en oeuvre à une température voisine de la température ambiante, par exemple entre 15°C et 30°C. A propos du déroulement de la réaction, il faut noter qu'elle donne naissance à du $B(OH)_3$ et à des ions $OH^-$ qui ont pour effet d'induire une augmentation du pH du milieu au cours de la réduction. Or à des valeurs de pH élevées, par exemple supérieures à 13, la réduction est ralentie de sorte qu'il peut être avantageux d'opérer dans un milieu tamponné pour avoir une vitesse de réduction bien déterminée. Aprés réduction on rince le format.

En début de réduction, la réaction concerne essentiellement les grains à d'oxyde cuivreux qui se trouvent en surface du substrat et qui sont en contact direct avec l'agent réducteur. Du fait de l'effet catalytique du cuivre métal, la réaction de réduction va se poursuivre ensuite dans l'épaisseur du format et ceci bien que les résines

utilisées ne présentent pas un caractère hydrophile particulièrement marqué. C'est donc en jouant principalement sur la durée du traitement qu'il est possible de contrôler aisément l'importance de la réduction opérée. Pour obtenir une résistivité répondant aux valeurs souhaitées, la durée du traitement qui est nécessaire est en général assez courte et, selon les proportions d'oxyde compris dans le substrat, elle se situe habituellement entre environ une minute et une quinzaine de minutes. Pour une durée de traitement donnée, il est possible d'agir encore sur la vitesse de réduction en ajoutant dans le milieu des accélérateurs variés comme par exemple de l'acide borique, de l'acide oxalique, de l'acide citrique, de l'acide tartrique ou des chlorures de métaux tels le chlorure de cobalt-II, de nickel-II, de fer-II, de manganèse-II, de cuivre-II.

Etant donné l'état très divisé du cuivre obtenu après le traitement réducteur, on devait s'attendre à ce que son oxydation à l'air soit rapide. Or on a constaté qu'il n'en est rien et que le niveau de la résistivité superficielle du format après réduction n'évolue pas pendant plusieurs jours de conservation à l'air ambiant.

Il est donc possible de stocker dans cet état le substrat réduit. On peut prévoir à titre de précaution soit un rinçage incomplet laissant des traces de réducteur à la surface du format, soit l'addition au bain de rincage d'un agent réducteur particulier par exemple d'hydroquinone soit la protection du format rincé et séché par enduction d'un film protecteur par exemple de photorésist.

Le substrat réduit peut ensuite être métallisé par dépôt d'une couche de cuivre, de nickel ou d'un autre métal. Cette métallisation peut être faite par voie électrochimique, mais il a été constaté et ceci constitue un des avantages essentiels liés à la mise en oeuvre des substrats selon l'invention, qu'elle peut être faite aussi directement par voie électrolytique. Dans certaines applications, il n'est pas rare de rechercher un dépôt de couche métallique d'au moins 20 microns, aussi la possibilité de pouvoir utiliser directement la voie électrolytique correspond-elle vraiment à un procédé industriellement rentable. Il est possible bien entendu de procéder, de manière classique, d'abord à une métallisation électrochimique, puis de renforcer ce premier dépôt par un dépôt ultérieur électrolytique. Pour avoir une description détaillée des conditions opératoires propres à la métallisation électrochimique on peut se reporter à l'ouvrage "Encyclopedia of Polymer Science and Technology, 1968, volume 8, pages 658 à 661". Les proportions des constituants du bain électrochimique, la durée de l'immersion du format, la température et les autres conditions opératoires sont déterminées dans chaque cas particulier de manière connue en soi pour obtenir les meilleurs résultats.

La métallisation par électrolyse est bien connue; cf. notamment "Encyclopedia of Polymer Science and Technology, 1968, volume 8, pages 661 à 663". Le format convenablement réduit constitue la cathode et le métal à déposer l'anode. Tous deux sont immergés dans un électrolyte traversé par un courant. Par exemple dans le cas d'un cuivrage électrolytique, le métal déposé peut procéder du cuivre monovalent ou bivalent et provenir d'un électrolyte cyanuré (cuivre monovalent) ou d'un électrolyte à base de sulfate, pyrophosphate ou fluoborate (cuivre bivalent). Plusieurs adjuvants peuvent être ajoutés dans l'électrolyte: un sel alcalin ou alcalino-terreux, un acide (bain de cuivrage acide au sulfate de cuivre) ou une base (bain d'étamage alcalin au stannate) pour augmenter la conductivité de l'électrolyte un agent tampon pour éviter les variations rapides du pH; des corps modifiant la structure des électrodépôts comme par exemple des colloïdes, des agents tensio-actifs, un phénol, un phénol sulfoné, un brillanteur minéral ou organique, un agent nivelant tel que par exemple la coumarine. La qualité de l'électrodépôt, qu'il soit d'un métal ou d'un alliage métallique, va dépendre de la composition de l'électrolyte et des conditions physiques de l'électrolyse (température, densité de courant cathodique et anodique, distance anode-cathode, conditionnement superficiel des électrodes, etc.) ; le réglage de ces différents paramètres sera fait dans chaque cas particulier de manière connue en soi.

Selon la durée du traitement électrolytique on pourra obtenir des couches métalliques dont l'épaisseur est de l'ordre du micromètre, couches enracinées dans le substrat et présentant une bonne cohésion, contrairement à ce qui se passe avec des dépôts "Electroless".

Le fait de pouvoir propager la réduction dans l'épaisseur du substrat va permettre d'engendrer les avantages suivants: lors de la métallisation, il y aura un ancrage profond du métal déposé dans le substrat résineux; dans le cas d'une soudure avec un apport de métal formant un alliage, l'alliage pourra migrer également à l'intérieur du substrat puisqu'il y a une réelle continuité du cuivre dans l'épaisseur du substrat.

Des substrats comportant une couche aussi mince de métal présentent un grand intérêt pour la réalisation de circuits imprimés, car ils permettent lors des traitements ultérieurs de gravure de supprimer les défauts et notamment la sous-gravure. On peut ainsi augmenter la densité de la circuiterie et augmenter la fiabilité des circuits.

Il va de soi que l'on peut obtenir aussi des dépots métalliques beaucoup plus importants, de l'ordre de 20 à 50 micromètres par exemple, dépôts correspondant aux techniques actuellement utilisées pour la réalisation de circuits imprimés. On peut de même déposer par fusion ou par voie électrolytique des couches d'alliage de type plomb/étain.

La réalisation de circuits imprimés à partir de substrats réduits peut alors se faire selon les procédés additifs classiques et la réalisation de circuits à partir de substrats réduits et métallisés par voie électrolytique, par gravure classique.

Le procédé selon l'invention permet donc d'obtenir des substrats métallisés qui comportent une couche de métal ancrée dans le polymère pouvant présenter une épaisseur aussi faible qu'un micron tout en étant cohérente et résistante. Ce procédé se distingue des procédés antérieurs tant par sa simplicité que par son faible coût et par le très grand nombre de possibilités ouvertes.

De plus sa technologie est adaptée aux équipement existants. Les possibilités de variantes sont très nombreuses, car à chaque étape du procédé il est possible de l'interrompre par exemple par un stockage du

produit semi-fini pour le reprendre ultérieurement.

Les exemples suivants donnes à titre non limitatif illustrent linvention et montrent comment elle peut être mise en oeuvre.

**Exemple 1**

Dans un mélangeur muni d'un puissant système d'agitation, désigné sous l'appellation de "pile" dans l'industrie papetière on introduit:

- 2000 l d'eau;
- 150 kg de fibre cellulosique sous forme de pâte à papier;
- le complément d'eau pour atteindre un volume de 3000 l environ;
- 115 kg de résine novolaque en poudre, contenant 8 % d'hexaméthylènetétramine (Résophéne PB 1119 commercialisé par Rhône-Poulenc);
- 15 l de solution de fécule cationique à 5 % d'extrait sec.

Après homogénéisation sous forte agitation il est introduit 4 l de silice colloïdale qui sont dispersés dans le milieu par une faible agitation de courte durée.

L'ensemble est alors vidé dans le "cuvier" où il est repris par un système de godets pour alimenter la machine papetière proprement dit.

Cette machine se présente sous la forme d'une toile métallique sans fin permettant un égouttage naturel de la pâte dans une première partie puis un égouttage forcé sur des caissons à vide. Après séparation de la nappe papetière, la toile métallique dans son trajet retour est décolmatée par de puissants jets d'eau.

Dans la première partie de la machine la régularité du dépôt est assurée conjointement par l'égouttage naturel et par un mouvement transversal de la couche de pâte. Ce mouvement est imprimé à la pâte par des règles latérales empèchant la pâte de déborder de part et d'autre de la toile.

L'ensemble de l'eau résultant de l'égoutage et du lavage de la toile est receuilli sous la machine et recyclée avec les fibres en suspension qu'elle contient, pour la préparation de la "pile" suivante.

On veillera à ce que le pH reste inférieur à 11 - 12.

Ce système présente deux avantages:

- les matières solides et notamment la résine qui aurait pu ne pas être retenues dans la nappe continue fabriquée par ce processus sont ainsi recyclées;
- les rejets polluants sont supprimés.

Néanmoins renouvellement de l'eau est important et au minimum de l'ordre de 15 à 20 %. Il correspond à l'eau retenue dans la nappe et qui sera éliminé lors du séchage de cette dernière.

La nappe continue après passage sur les caissons à vide et séparation de la toile métallique support a une épaisseur de 5 à 8 mm fonction du taux d'égouttage, du degré d'affinage de la pâte à papier utilisée, de l'utilisation ou non d'un rouleau calandreur appuyant sur le cylindre de détour de la toile métallique.

Cette nappe supportée par un tapis défilant à la même vitesse que la toile métallique utilisée pour sa confection soit environ 2 m/mn, a une largeur de 2,50 m. Elle est recoupée en continu par deux jets d'air qui réduisent sa dimension à 2,20 m en éliminant de chaque côte les bords dont l'épaisseur n'est pas constante.

Les chutes sont récupérées en continu; elles sont recyclables et seront introduites dans la pile suivante.

**Exemple 2**

Une opération analogue dans la pratique à celle de l'exemple 1 est conduite avec:

- 100 kg de fibre cellulosique;
- 100 kg de mica muscovite 16 mesh traité préalablement par 1 % en poids de vinyltriéthoxysilane;
- 120 kg de résine phénolique Novolaque contenant 8 % d'hexaméthylène tétramine.

**Exemple 3**

Toujours de façon anologue à l'exemple 1, une opération est conduite avec:

- 130 kg de fibre cellulosique sous forme de pâte à papier;
- 50 kg de fibre de verre dispersable dans l'eau ayant une longueur comprise entre 10 et 30 mm;
- 120 kg de résine phénolique Novolaque contenant 8 % d'hexaméthylène tétramine.

**Exemple 4**

Toujours de façon anologue à l'exemple 1, une opération est conduite avec:
- 150 kg de fibre cellulosique sous forme de pâte à papier;
- 15 kg de fluide PB;
- 50 kg de résine phénolique novolaque contenant 5 à 10 % d'hexaméthylènetétramine.

**Exemple 5** (formation d'une feuille sans résine)

Dans la "pile" sont introduits successivement:
- 2000 l d'eau
- 115 kg de KEVLAR sous forme de pulpe;
- 200 kg de fibre cellulosique sous forme de pâte à papier;
- le complément en eau pour atteindre un volume de 3000 l;
- 50 kg de fibre de verre de 3 mm;
- 15 l de solution de fécule cationique.

La forte agitation du mélange est alors arrêtée.
- 4 l de solution de silice colloïdale sont alors dispersés dans ce milieu avec le minimum d'agitation.

L'ensemble est transféré dans le cuvier et alimente la machine papetière pour produire une nappe continue de 7 mm d'épaisseur, en 2,50 m de large, recoupée à 2,20 m par des jets d'air latéraux. La vitesse de production de la nappe est de 2 m/mn.

**Exemple 6**

Dans la "pile" sont introduits successivement:
- 2000 l d'eau;
- 5 kg de fibre polynosique BX de longueur moyenne d'environ 5 mm;
- 150 kg de fibre cellulosique sous forme de pâte à papier;
- le complément en eau pour atteindre un volume de 3000 l;
- 90 kg de fibre céramique lavée (exempte de particules non fibreuses);
- 15 l de solution de fécule cationique.

Après une homogénéisation soignée, l'agitation est arrêtée;
- 4 l de solution de silice colloïdale sont alors dispersés dans le milieu avec le minimum d'agitation.

Le milieu est transféré dans le cuvier d'où est alimentée la machine papetière. La nappe continue produite a une épaisseur de 5 mm, une largeur de 2,50 m recoupée à 2,20 m par 2 jets d'air latéraux. La vitesse de production de la nappe est de 2 m/mn.

**Exemple 7**

Les nappes résultant des exemples 5 et 6 ont une bonne tenue mécanique bien que non séchées. Elles sont immergées en continu dans une solution hydroalcoolique de Résol (Résophène PL 3598) contenant 55 % de résine qui a été rediluée de moitié avec un mélange eau/alcool.

En sortie de bac d'imprégnation la nappe est calandrée entre deux cylindres pour régler la quantité de résine retenue.

La nappe est alors séchée en étuve ventilée à 140° C pendant 5 mn.

**Exemple 8**

Les nappes résultant des essais 1, 2, 3, 4 et 7 après séchage en étuve ventilée sont imprégnées par immersion dans une solution hydroalcoolique de résine comme à l'exemple 7 contenant 50 % en poids (par rapport à la résine) d'oxyde cuivreux en suspension (diamètre du $Cu_2O$ environ 1 micromètre). Les nappes imprégnées sont séchées en étuve ventilée à 140° C pendant 5 mn.

**Exemple 9**

Les nappes des essais 1, 2, 3, 4 et 7, après séchage en étuve ventilée sont imprégnées par une solution hydroalcoolique de résol chargé à 50 % de $Cu_2O$ (diamètre des particules environ 1 micromètre). Cette imprégnation est faite par pulvérisation de la solution du résol chargé, sur la face supérieure de la nappe séchée.

**Exemple 10**

Les nappes résultant des essais 1, 2, 3 et 4 subissent le traitement décrit à l'exemple 9 <u>avant</u> séchage en étuve.

**Exemple 11**

Les essais décrits aux exemples 9 et 10 sont conduits avec une résine d'imprégnation non chargée de $Cu_2O$.

La nappe enduite passe ensuite sous une tête "Saladin" qui délivre du $Cu_2O$ sec et saupoudre la face imprégnée.

La tête Saladin est constituée par un cylindre métallique dont la surface est grainée (la longueur de sa génératrice correspond à la largeur utile de la nappe enduite). Ce cylindre est surmonté par une trémie alimentant la poudre de $Cu_2O$.

Lors de sa rotation le cylindre grainé entraîne un peu de $Cu_2O$ qui est détaché du cylindre et tombe sur la nappe, par l'action d'une brosse également cylindrique, d'axe parallèle à celui du cylindre, et dont les poils tangentent le cylindre.

Le débit de $Cu_2O$ est réglé par l'écoulement de la trémie, la vitesse de rotation du cylindre grainé et de la brosse et la vitesse de défilement de la nappe.

La quantité de 20 déposé par $m^2$ de nappe est d'environ 15 à 16 $g/m^2$

**Exemple 12**

On procède à l'enduction d'un papier kraft de $120g/m^2$ ayant déjà été imprégné à l'aide d'une résine phénolique (Résophène PL 3598) suivi d'un séchage à 150° C pendant 5 mn pour un dépôt de $30g/m^2$ de résine environ.

La composition de la résine chargée est dans ce cas:

33 % de résine phénolique pure (Résol PL 4531 de Rhône-Poulenc)

33 % de solvant de la résine

33 % de $Cu_2O$.

L'enduction est réalisée en "plein bain", l'homogénéité de la suspension étant assurée par une circulation en canard sur le bac d'imprégnation, à l'aide d'une pompe de circulation.

Le papier émergeant du bain est calibré par passage entre deux racles fixes situés au-dessus du bain de façon que l'excès de résine retombe dans celui-ci.

Le papier imprégné est alors séché en continu en étuve ventilée. à environ 100° C pendant 3 mn.

Le grammage final du papier enduit est de 370 $g/m^2$ se répartissant ainsi:

- papier : 120 g
- Resol PL 3598 : 30 g
- Resol PL 4531 :125 g
- $Cu_8O$ : 95 g

**Exemple 13**

On prend dans les nappes obtenues au cours des exemples 8 - 9 et 10 des formats d'environ 100 x 100 cm. Ces formats secs, dans lesquels la résine est demeurée sous forme non durcie sont pressés à chaud en 50 mn à 160° C avec un cycle d'élévation progressive de la pression de 20 à 90 Mpa. Les plaques pressées résultant de l'opération sont de couleur rouge brique et ont une épaisseur qui varie de 1,5 à 1,7 mm.

On découpe dans ces plaques des formats de 20 x 20 que l'on décape superficiellement par sablage.

**Exemple 14**

On prend dans les nappes obtenues au cours des exemples 7 des formats d'environ 100 x 100 cm.

On découpe de même dans les surfaces de papiers enduits selon l'exemple 12 des formats d'environ 100 x 100 cm.

On réalise des stratifiés composés respectivement par une couche de papier enduit, par un format et par une autre couche de papier enduit.

On presse en 45 mn à 160°C les stratifiés obtenus, la pression évoluant de 20 Mpa à 90 Mpa. Les plaques pressées sont homogènes, ne se délaminent pas et sont en surface de couleur rouge brique. Elles ont une épaisseur d'environ 1,9 à 2 mm. On découpe dans ces plaques des formats de 20 x 20 que l'on décape superficiellement par sablage.

**Exemple 15**

On reprend les formats obtenus selon les exemples 13 et 14. On traite ces formats par la solution réductrice suivante:

Dans un erlen de 1000 ml on introduit dans l'ordre sous agitation et après dilution de chaque constituant:
- 500 ml d'eau distillée,
- 2,5 g de soude en pastilles,
- 5 g de sel de sodium d'un carboxyméthylcellulose (type 7 ME, "médium viscosity", PM 250 000 d'HERCULES),
- 25 g de borohydrure de potassium,
- 5 $cm^3$ d'une solution aqueuse à 1 % de Cemulsol DB 311 de SFOS.

Le substrat est enduit par la solution réductrice et après un contact de 3 mn, la solution et les sous-produits de la réaction sont éliminés par lavage à l'eau distillée accompagné d'un léger brossage. Le substrat est rincé à l'alcool et séché. La résistance électrique mesurée entre deux points de la surface distants d'une vingtaine de cm, à l'aide d'électrodes ponctuelles varie de 10 à 70 ohms.

La surface est cuivrée et conductrice de l'électricité. La plaque ainsi obtenue est alors soumise aux opérations permettant la fabrication d'un circuit imprimé double face:
- Dépôt recto-verso de phtorésist.
- Insolation recto-verso au travers de masque.
- Développement du photorésist.
- Renforcement électrolytique dans un bain acide de sulfate de cuivre avec anode de cuivre, dans les plages sans photorésist.

Lorsque l'épaisseur du dépôt atteint une trentaine de micromètres en moins d'une heure, le circuit est rincé à l'eau.
- Strippage du photorésist restant.
- Gravure non sélective au perchlorure de fer jusqu'à disparition complète du cuivre dans les zones non renforcées.
- Après rincage à l'eau, immersion rapide dans un bain d'acide sulfurique dilué pour redonner un aspect brillant au circuit. - Rincage soigneux à l'eau distillée puis à l'alcool et enfin sèchage.

Au terme de cette opération nous disposons d'un circuit imprimé. double face.

**Revendications**

pour les Etats Contractants: BE, CH, DE, FR, GB, IT, LI, LU, NL, SE

1. Substrats métallisables par traitement de réduction éventuellement suivi d'une métallisation par voie électrolytique, destinés à la réalisation de circuits imprimés, les dits substrats comprenant une âme centrale constituée essentiellement d'une résine thermodurcissable renfermant éventuellement une charge inerte, et sur une ou deux de ses faces d'au moins une couche obtenue par chauffage et pressage à partir d'une composition de résine thermodurcissable chargée par un oxyde métallique non conducteur dont le degré d'oxydation est choisi de manière à permettre une réduction facile par un borohydrure et qui est susceptible de former intermédiairement des hydrures métalliques instables, caractérisés en ce que l'âme centrale comprend en outre de matière fibreuse cellulosique et/ou de paillettes de mica.

2. Substrats selon la revendication 1, caractérisés en ce que la résine thermodurcissable utilisée dans l'âme centrale est une résine phénolique de type novolaque.

3. Substrats selon la revendication 1, caractérisés en ce que la résine thermodurcissable de la ou des couches externes est choisie dans la famille constituée par les résines phénoliques, les résines époxydes, les résines obtenues à partir de prépolmères à groupements imides.

4. Substrats selon la revendication 3, caractérisés en ce que la ou les couches externes sont constituées de résine thermodurcissable renforcées par un substrat poreux cellulosique.

5. Substrats selon la revendication 1 ou 3, caractérisés en ce que la résine thermodurcissable de la ou des couches externes est obtenue à partir de prépolymères à groupements imides.

6. Substrats selon la revendication 1, caractérisés en ce que l'oxyde métallique non conducteur est l'oxyde cuivreux.

7. Procédé d'obtention des substrats selon la revendication 1 comprenant les étapes suivantes; on prépare une dispersion aqueuse des fibres cellulosiques et/ou des paillettes de mica ainsi que de la résine thermodurcissable sous forme de poudre et éventuellement de la charge pulvérulente inerte, puis on forme une nappe par élimination de l'eau, léger pressage et séchage, puis on dépose sur une ou deux faces par enduction, pulvérisation ou dépôt d'un support cellulosique enduit, la composition de résine thermodurcissable chargée de l'oxyde métallique non conducteur, et enfin on presse le tout sous une pression comprise entre 10 et 300 MPa et à une température comprise entre 70 et 280°C.

8. Procédé d'obtention des substrats selon la revendication 7, caractérisé en ce que la résine thermodurcissable utilisée dans la première étape est une résine phénolique de type novolaque renfermant de l'hexaméthylènetétramine.

9. Procédé d'obtention de substrats métallisés caractérisés en ce que les substrats métallisables selon la revendication 1 subissent un traitement de décapage mécanique et/ou chimique suivi d'un traitement de réduction par un borohydrure alcalin, éventuellement suivi d'une métallisation par voie électrolytique.

**Revendications** pour l'Etat Contractant: AT

1. Procédé d'obtention de substrats métallisables par traitement de réduction éventuellement suivi d'une métallisation par voie électrolytique, destinés à la réalisation de circuits imprimés, les dits substrats comprenant une âme centrale constituée essentiellement d'une résine thermodurcissable renfermant éventuellement une charge inerte, et sur une ou deux de ses faces d'au moins une couche obtenue par chauffage et pressage à partir d'une composition de résine thermodurcissable chargée par un oxyde métallique non conducteur dont le degré d'oxydation est choisi de manière à permettre une réduction facile par un borohydrure et qui est susceptible de former intermédiairement des hydrures métalliques instables, ledit procédé comprenant les étapes suivantes: on prépare une dispersion aqueuse des fibres cellulosiques et/ou des paillettes de mica ainsi que de la résine durcissable sous forme de poudre et éventuellement de la charge pulvérulente inerte, on forme une nappe par élimination de l'eau, léger pressage et séchage, puis on dépose sur une ou deux faces par enduction, pulvérisation ou dépôt d'un support cellulosique enduit, la composition de résine thermodurcissable chargée d'un oxyde métallique non conducteur, et enfin que l'on presse le tout sous une pression comprise entre 10 et 300 Mpa et à une température comprise entre 70 et 280°C.

2. Procédé selon la revendication 1, caractérisé en ce que la résine thermodurcissable utilisée dans l'âme centrale est une résine phénolique de type novolaque.

3. Procédé selon la revendication 1, caractérisé en ce que la résine thermodurcissable de la ou des couches externes est choisie dans la famille constituée par les résines phénoliques, les résines époxydes, les résines obtenues à partir de prépolmères à groupements imides.

4. Procédé selon la revendication 3, caractérisé en ce que la ou les couches externes sont constituées de résine thermodurcissable renforcées par un substrat poreux cellulosique.

5. Procédé selon la revendication 1 ou 3, caractérisé en ce que la résine thermodurcissable de la ou des couches externes est obtenue à partir de prépolymères à groupements imides.

6. Procédé selon la revendication 1, caractérisé en ce que l'oxyde métallique non conducteur est l'oxyde cuivreux.

7. Procédé selon la revendication 1, caractérisé en ce que la résine thermodurcissable utilisée dans l'âme centrale est une résine phénolique de type novolaque sous forme de podre renfermant de l'hexaméthylènetétramine.

8. Procédé d'obtention de substrats métallisés caractérisé en ce que les substrats métallisables obtenus selon l'une quelconque des revendications précédentes subissent un traitement de décapage mécanique et/ou chimique suivi d'un traitement de réduction par un borohydrure alcalin, éventuellement suivi d'une métallisation par voie électrolytique.

**Patentansprüche**

1. Träger, die durch Reduktionsbehandlung, gegebenenfalls gefolgt von einer elektrolytischen Metallisierung, metallisierbar und zur Herstellung gedruckter Schaltungen bestimmt sind, wobei die Träger einen zentralen Kern umfassen, der im wesentlichen aus einem wärmehärtbaren Harz das gegebenenfalls einen inerten Füllstoff enthält, und aus zumindest einer Schicht auf einer oder zwei seiner Seiten gebildet ist, wobei diese Schicht durch Erhitzen und Pressen eines Ausgangsmaterials erhalten worden ist, das aus einer wärmehärtbaren Harzzusammensensetzung, die mit einem nichtleitenden Metalloxid versetzt ist, besteht,

wobei die Oxidationsstufe des Metalloxids so gewählt ist, daß eine leichte Reduktion durch ein Borhydrid möglich ist und wobei das Metalloxid instabile Metallhydride intermediär bilden kann, dadurch gekennzeichnet, daß der zentrale Kern unter anderem Zellulosefasergut und/oder Glimmerblättchen umfaßt.

2. Träger nach Anspruch 1, dadurch gekennzeichnet, daß das im zentralen Kern verwendete wärmehärtbare Harz ein Novolak-Phenolharz ist.

3. Träger nach Anspruch 1, dadurch gekennzeichnet, daß das wärmehärtbare Harz der Außenschicht oder der Außenschichten aus den Phenolharzen, den Epoxyharzen und den Harzen, die ausgehend von Vorpolymeren mit Imidgruppen erhalten worden sind, ausgewählt ist.

4. Träger nach Anspruch 3, dadurch gekennzeichnet, daß die Außenschicht oder die Außenschichten aus einem wärmehärtbaren Harz, das durch ein poröses Zellulosesubstrat verstärkt ist, bestehen.

5. Träger nach Anspruch 1 oder 3, dadurch gekennzeichnet, daß das wärmehärtbare Harz der Außenschicht oder der Außenschichten ausgehend von Vorpolymeren mit Imidgruppen erhalten worden ist.

6. Träger nach Anspruch 1, dadurch gekennzeichnet, daß das nichtleitende Metalloxid das Kupfer (I)-oxid ist.

7. Verfahren zur Herstellung von Trägern nach Anspruch 1, das folgende Schritte umfaßt: Man stellt eine wässerige Dispersion aus Zellulosefasern und/oder Glimmerblättchen sowie aus dem wärmehärtbaren Harz in Pulverform und gegebenenfalls aus inertem, feinpulverigem Füllstoff her, anschließend bildet man ein Vlies durch Entfernen des Wassers, leichtes Pressen und Trocknen, anschließend bringt man die Zusammensetzung des mit dem nichtleitenden Metalloxid versetzten wärmehärtbaren Harzes auf einer oder zwei Seiten durch Überziehen, Spritzen oder Aufbringen eines überzogenenen Zelluloseträgers auf, und schließlich preßt man das Ganze mit einem Druck zwischen 10 und 300 MPa und bei einer Temperatur zwischen 70 und 280°C.

8. Verfahren zur Herstellung von Trägern nach Anspruch 7, dadurch gekennzeichnet, daß das im ersten Schritt verwendete wärmehärtbare Harz ein Novolak-Phenolharz ist, das Hexamethylentetramin enthält.

9. Verfahren zur Herstellung metallisierter Träger, dadurch gekennzeichnet, daß die metalliserbaren Träger nach Anspruch 1 mechanisch und/oder chemisch blank geputzt werden und anschließend einer Reduktionsbehandlung durch ein Alkaliborhydrid, gegebenenfalls gefolgt von einer elektrolytischen Metallisierung, unterworfen werden.

**Patentansprüche** für den Vertragsstaat AT

1. Verfahren zur Herstellung von Trägern, die durch Reduktionsbehandlung, gegebenenfalls gefolgt von einer elektrolytischen Metallisierung, metallisierbar und zur Herstellung gedruckter Schaltungen bestimmt sind, wobei die Träger einen zentralen Kern umfassen, der im wesentlichen aus einem wärmehärtbaren Harz, das gegebenenfalls einen inerten Füllstoff enthält, und aus zumindest einer Schicht auf einer oder zwei seiner Seiten gebildet ist, wobei diese Schicht durch Er-und Pressen eines Ausgangsmaterials erhalten worden ist, das aus einer wärmehärtbaren Harzzusammensetzung, die mit einem nichtleitenden Metalloxid versetzt ist, besteht, wobei die Oxidationsstufe des Metalloxids so gewählt ist, daß eine leichte Reduktion durch ein Borhydrid möglich ist und wobei das Metalloxid instabile Metallhydride intermediär bilden kann, wobei das Verfahren folgende Schritte umfaßt: Man stellt eine wässerige Dispersion aus Zellulosefasern und/oder Glimmerblättchen sowie aus dem hältbaren Harz in Pulverform und gegebenenfalls aus inertem, feinpulverigen Füllstoff her, man bildet ein Vlies durch Entfernen des Wassers, leichtes Pressen und Trocknen, anschließend bringt man die Zusammensetzung des mit einem nichtleitenden Metalloxid versetzten wärmehärtbaren Harzes auf einer oder zwei Seiten durch Überziehen, Spritzen oder Aufbringen eines überzogenen Zelluloseträgers auf, und schließlich daß man das Ganze mit einem Druck zwischen 10 und 300 MPa und bei einer Temperatur zwischen 70 und 280°C preßt.

2. Verfahren nach Anspruch 1, dadurch gekennzeichnet, daß das im zentralen Kern verwendete wärmehärtbare Harz ein Novolak-Phenolharz ist.

3. Verfahren nach Anspruch 1, dadurch gekennzeichnet, daß das wärmehärtbare Harz der Außenschicht oder der Außenschichten aus den Phenolharzen, den Epoxyharzen und den Harzen, die ausgehend von Vorpolymeren mit Imidgruppen erhalten worden sind, ausgewählt ist.

4. Verfahren nach Anspruch 3, dadurch gekennzeichnet, daß die Außenschicht oder die Außenschichten aus einem wärmehärtbaren Harz, das durch ein poröses Zellulosesubstrat verstärkt ist, bestehen.

5. Verfahren nach Anspruch 1 oder 3, dadurch gekennzeichnet, daß das wärmehärtbare Harz der Außenschicht oder der Außenschichten ausgehend von Vorpolymeren mit Imidgruppen erhalten worden ist.

6. Verfahren nach Anspruch 1, dadurch gekennzeichnet, daß das nichtleitende Metalloxid das Kupfer(I)-oxid ist.

7. Verfahren nach Anspruch 1, dadurch gekennzeichnet, daß das im zentralen Kern verwendete wärmehärtbare Harz ein pulverförmiges Novolak-Phenolharz ist, das Hexamethylentetramin enthält.

8. Verfahren zur Herstellung metallisierter Träger, dadurch gekennzeichnet, daß die nach einem der vorhergehenden Ansprüche erhaltenen metallisierbaren Träger mechanisch und/oder chemisch blank geputzt werden und anschließend einer Reduktionsbehandlung durch ein Alkaliborhydrid, gegebenenfalls gefolgt von einer elektrolytischen Metallisierung, unterworfen werden.

**Claims** for the contracting States BE CH DE FR GB IT LI LU NL SE

1. Substrates which can be metallized by a reduction treatment optionally followed by a metallization by an electrolytic route, which are intended for producing printed circuits, the said substrates comprising a central core consisting essentially of a heat-curable resin optionally containing an inert filler and, on one or two of its faces, of at least one layer obtained by heating and pressing from a heat-curable resin composition filled with a nonconductive metal oxide whose degree of oxidation is chosen so as to permit an easy reduction with a borohydride and which is capable of forming intermediate unstable metal hydrides, characterized in that the central core additionally comprises cellulosic fibrous material and/or mica flakelets.

2. Substrates according to claim 1, characterized in that the heat-curable resin employed in the central core is a phenolic resin of novolak type.

3. Substrates according to claim 1, characterized in that the heat-curable resin of the outer layer(s) is chosen from the group consisting of phenolic resins, epoxy resins and resins obtained from prepolymers containing imide groups.

4. Substrates according to claim 3, characterized in that the outer layer(s) consist of heat-curable resin reinforced with a cellulosic porous substrate.

5. Substrates according to claim 1 or 3, characterized in that the heat-curable resin of the outer layer(s) is obtained from prepolymers containing imide groups.

6. Substrates according to claim 1, characterized in that the nonconductive metal oxide is cuprous oxide.

7. Process for obtaining the substrates according to claim 1, comprising the following stages: an aqueous dispersion of the cellulosic fibres and/or mica flakelets and of the heat-curable resin in powder form and optionally of the inert pulverulent filler is prepared, then a sheet is formed by removing water, slight pressing and drying, then the heat-curable resin composition filled with the nonconductive metal oxide is deposited on one or both faces by coating, spraying or deposition of a coated cellulosic support, and finally the whole is pressed under a pressure of between 10 and 300 MPa and at a temperature of between 70 and 280° C.

8. Process for obtaining the substrates according to claim 7, characterized in that the heat-curable resin employed in the first stage is a phenolic resin of novolak type containing hexamethylenetetramine.

9. Process for obtaining metallized substrates characterized in that the metallizable substrates according to claim 1 undergo a mechanical and/or chemical scouring treatment followed by a reduction treatment with an alkali metal borohydride, optionally followed by a metallization by an electrolytic route.

**Claims** for the contracting State AT

1. Process for obtaining substrates which can be metallized by a reduction treatment optionally followed by a metallization by an electrolytic route, which are intended for producing printed circuits, the said substrates comprising a central core consisting essentially of a heat-curable resin optionally containing an inert filler and, on one or two of its faces, of at least one layer obtained by heating and pressing from a heat-curable resin composition filled with a nonconductive metal oxide whose degree of oxidation is chosen so as to permit an easy reduction with a borohydride and which is capable of forming intermediate unstable metal hydrides, the said process comprising the following stages: an aqueous dispersion of the cellulosic fibres and/or mica flakelets and of the curable resin in powder form and optionally of the inert pulverulent filler is prepared, a sheet is formed by removing water, slight pressing and drying, then the heat-curable resin composition filled with a nonconductive metal oxide is deposited on one or both faces by coating, spraying or deposition of a coated cellulosic support, and finally the whole is pressed under a pressure of between 10 and 300 Mpa and at a temperature of between 70 and 280° C.

2. Process according to claim 1, characterized in that the heat-curable resin employed in the central core is a phenolic resin of novolak type.

3. Process according to claim 1, characterized in that the heatcurable resin of the outer layer(s) is chosen from the group consisting of phenolic resins, epoxy resins and resins obtained from prepolymers containing imide groups.

4. Process according to claim 3, characterized in that the outer layer(s) consist of heat-curable resin reinforced with a cellulosic porous substrate.

5. Process according to claim 1 or 3, characterized in that the heat-curable resin of the outer layer(s) is obtained from prepolymers containing imide groups.

6. Process according to claim 1, characterized in that the nonconductive metal oxide is cuprous oxide.

7. Process according to claim 1, characterized in that the heat-curable resin employed in the central core is a phenolic resin of novolak type in the form of powder containing hexamethylenetetramine.

8. Process for obtaining metallized substrates characterized in that the metallizable substrates obtained according to any one of the preceding claims undergo a mechanical and/or chemical scouring treatment followed by a reduction treatment with an alkali metal borohydride, optionally followed by a metallization by an electrolytic route.